# EUROPÄISCHE PATENTSCHRIFT

(11) **EP 2 301 148 B1**
(45) Veröffentlichungstag und Bekanntmachung des Hinweises auf die Patenterteilung: **25.04.2012**
(21) Anmeldenummer: 09779714.6
(22) Anmeldetag: 10.06.2009
(51) Int. Cl.: H03G 1/00, H03F 3/217

(54) **AUDIOVERSTÄRKER SOWIE VERFAHREN ZUR UMKONFIGURATION EINES AUDIOVERSTÄRKERS**
AUDIO AMPLIFIER AND METHOD FOR RECONFIGURING AN AUDIO AMPLIFIER
AMPLIFICATEUR AUDIO ET PROCÉDÉ POUR RECONFIGURER UN AMPLIFICATEUR AUDIO

(30) Priorität: 09.07.2008 DE 102008040291
(43) Veröffentlichungstag der Anmeldung: 30.03.2011
(73) Patentinhaber: Robert Bosch GmbH, 70442 Stuttgart (DE)
(72) Erfinder: MAIER, Martin, 84405 Dorfen (DE); TAFFNER, Josef, 93093 Donaustauf (DE); PLAGER, Josef, 94327 Bogen (DE)
(86) Internationale Anmeldenummer: PCT/EP2009/057204
(87) Internationale Veröffentlichungsnummer: WO 2010/003756

(56) Entgegenhaltungen:
- US-A- 5 789 975
- US-B2- 6 980 058

## Beschreibung

Die Erfindung betrifft einen Audioverstärker zur Verstärkung eines Eingangssignals in ein Ausgangssignal mit einer Ausgangsverstärkerstufe, wobei die Ausgangsverstärkerstufe zur Verstärkung eines Zwischensignals in das Ausgangssignal als ein im Schaltbetrieb arbeitender Verstärker ausgebildet ist. Die Erfindung betrifft im Weiteren ein Verfahren zur Umrüstung eines Audioverstärkers.

### Stand der Technik

Audioverstärker werden in vielen bekannten Bauformen in Musikanlagen, zum Beispiel für den Heimgebrauch oder zur Bereitstellung von Musik in Kinosälen, Diskotheken, etc., aber auch in Beschallungsanlagen, wie sie beispielsweise in öffentlichen Gebäuden, Schulen, Universitäten, etc. zur Verbreitung von Durchsagen bekannt sind, eingesetzt. Derartige Audioverstärker können auf einem beliebigen Verstärketprinzip basieren und vereinigen die Eigenschaft, dass ein Eingangssignal in ein verstärktes Ausgangssignal umgesetzt wird.

Allerdings haben sich bei den Ausgangsschnittstellen der Audioverstärker Standards durchgesetzt, wobei zur Zeit maßgeblich zwei unterschiedliche Technologien zur Umsetzung der Standards verwendet werden, die sich in der Art unterscheiden, wie die elektromechanischen Schallwandler mit dem Ausgangssignal gespeist werden.

Zum einen ist der Niederimpedanzbetrieb von Audioverstärkern bekannt, wobei der Audioverstärker elektrisch gesehen eine niederohmige, gesteuerte Spannungsquelle ist, und direkt die angeschlossenen Lautsprecher beziehungsweise elektromechanischen Schallwandler antreibt. Allerdings erfordert diese Technologie bei der Beschallung von größeren Gebäuden oder Plätzen aufgrund der nötigen Ströme und der Länge der Lautsprecherleitungen oftmals einen unverhältnismäßig großen Leiterquerschnitt der Lautsprecherleitung.

Insbesondere bei derartigen Anwendungen wird auf eine andere Technologie zurückgegriffen, den Hochimpedanzbetrieb, welche auch unter dem Begriff 100-Volt-Technik bekannt ist. Bei dieser Technologie wird das Ausgangssignal des Audioverstärkers mittels eines Niederfrequenz-Übertragers auf 100 Volt transformiert und ähnlich wie bei Energieverteilnetzen auf diesem Spannungsniveau an mehrere parallel geschaltene Lautsprecher übertragen. Zur spannungs- und impedanzmäßigen Anpassung verfügt jeder einzelne der Lautsprecher über einen eigenen Übertrager bzw. Transformator. Der Vorteil der Technologie ist, dass zur Versorgung Lautsprecherleitungen mit geringem Querschnitt verwendet werden können, eine Erweiterung des Beschallungssystems durch das Parallelschließen weiterer Lautsprecher sehr leicht möglich ist und eine pegelmäßige Anpassung einzelner Lautsprecher durch Anzapfungen am Übertrager bzw. Transformator im Lautsprecher möglich ist. Hochimpedanzsysteme sind nicht auf einen Spannungspegel von 100 Volt beschränkt, so ist zum Beispiel auch ein Spannungspegel von 70 Volt gebräuchlich.

### Offenbarung der Erfindung

Ein allgemeiner Audioverstärker ist in der Druckschrift US 6,980,058 beschrieben, der durch eine Rückkopplung eine konstante maximale Ausgangsleistung unabhängig von der Impedanz des angeschlossenen Lautsprechersystems ermöglicht.

Die Druckschrift US 5,789,975 , die wohl den nächstkommenden Stand der Technik bildet, betrifft einen analogen Signal- bzw. Audioverstärker, welcher ein Eingangssignal aufnimmt und über einen D-Class-Verstärker verstärkt. Als eine Besonderheit dieses Audioverstärkers wird herausgestellt, dass die maximale Ausgangsleistung variiert werden kann, während die Versorgungsspannung des D-Class-Verstärkers konstant gehalten wird. Dies wird dadurch erreicht, dass das Eingangssignal in dem D-Class-Verstärker in Abhängigkeit der gewünschten maximalen Ausgangsleistung des Audioverstärkers in einem Begrenzerteil auf eine Grenzspannung beschränkt wird. Für den Fall, dass die maximale Ausgangsleistung des Audioverstärkers geändert werden soll, wird vorgeschlagen, ein Begrenzerteil durch ein neues Begrenzerteil mit einer unterschiedlichen Grenzspannung zu ersetzen oder die Grenzspannung zu ändern, indem ein Begrenzungskreis verwendet wird, in dem die Grenzspannung eingestellt werden kann.

Im Rahmen der Erfindung wird ein Audioverstärker mit den Merkmalen des Anspruchs 1 und ein Verfahren zur Umkonfiguration eines bzw. des Audioverstärkers mit den Merkmalen des Anspruchs 10 offenbart. Bevorzugte oder vorteilhafte Ausführungsformen der Erfindung ergeben sich aus den Unteransprüchen, der nachfolgenden Beschreibung sowie den beigefügten Figuren.

Der erfindungsgemäße Audioverstärker ist zur Verstärkung eines Eingangssignals in ein Ausgangssignal geeignet und/oder ausgebildet. Der Audioverstärker kann beispielsweise in Musikanlagen oder - bevorzugt - in Beschallungsanlagen, insbesondere bei Public-Adress-Systemen zur Beschallung von komplexen Bereichen eingesetzt werden. Das Ausgangssignal des Audioverstärkers ist vorzugsweise als das Signal definiert, welches an elektromechanische Schallwandler und/oder Lautsprecher ausgegeben wird. Das Eingangssignal ist bevorzugt als ein analoges Signal ausgebildet, welches beispielsweise von einem Mikrofon oder einer anderen Audioquelle stammt.

Der Audioverstärker umfasst neben weiteren, optionalen Komponenten mindestens eine Ausgangsverstärkerstufe, welche zur Verstärkung eines Zwischensignals in das Ausgangssignal geeignet und/oder ausgebildet ist. Das Zwischensignal ist insbesondere als ein auf Basis des Eingangssignals erzeugtes Signal ausgebildet.

Die Ausgangsverstärkerstufe ist als ein im Schaltbetrieb arbeitender Verstärker realisiert, insbesondere ein Verstärker, welcher ein pulsweitenmoduliertes Signal, das auf Basis des Eingangssignals und/oder des Zwischensignals erzeugt ist bzw. dieses repräsentiert, verstärkt.

Im Rahmen der Erfindung wird vorgeschlagen, eine Begrenzereinrichtung in den Audioverstärker zu integrieren, welche programmtechnisch und/oder schaltungstechnisch ausgebildet ist, auf Basis des Eingangssignals das Zwischensignal zu erzeugen, wobei der Pegel des Zwischensignals in Abhängigkeit eines stellbaren Maximalpegels stets derart begrenzt ist, dass das Ausgangssignal unabhängig vom Eingangssignal den Maximalpegel nicht überschreitet.

Der Erfindung liegt die Idee zu Grunde, einen Audioverstärker vorzuschlagen, welcher flexibel sowohl für den Niederimpedanzbetrieb als auch für den Hochimpedanzbetrieb verwendbar ist. Durch den stellbaren Maximalpegel ist der Audioverstärker bevorzugt nicht auf bestimmte, diskrete Ausgangsleistungen beschränkt, sondern kann in einem weiten Bereich in der Ausgangsleistung bzw. in dem Maximalausgangspegel skaliert werden. Ein weiterer Vorteil liegt darin, dass im Hochimpedanzbetrieb kein Übertrager oder Transformator am Ausgang des Audioverstärkers benötigt wird.

Ein weiterer nutzbarer Vorteil der Erfindung kann sich daraus ergeben, dass bei vielen Beschallungsaufgaben Nieder- und Hochimpedanzanwendungen gemischt verbaut werden. So kann es zum Beispiel sinnvoll sein, die Beschallung eines Hauptraums mit Bühne in Niederimpedanztechnologie auszuführen, Nebenräume, Gänge, etc. aber in Hochimpedanztechnologie zu realisieren. Bislang war es notwendig, entweder verschiedene Audioverstärker vorzuhalten oder umschaltbare Audioverstärker bereitzustellen, welche meist in Abhängigkeit der Betriebsart unterschiedliche interne Versorgungsspannungen bereitstellen mussten. Gegebenenfalls mussten zudem Transformatoren bzw. Übertrager am Ausgang des Audioverstärkers angeschlossen werden. Im Gegensatz hierzu wird bei dem neuartigen Audioverstärker die maximale Ausgangsspannung bzw. Pegelspannung nicht ausschließlich durch die interne Versorgungsspannung, sondern durch die Begrenzereinrichtung realisiert, welche das Audiosignal in einem Kleinsignalbereich, also vor der Ausgangsverstärkerstufe begrenzt. Bei einer bevorzugten Ausführungsform ist die Ausgangsverstärkerstufe mit nur einer einzigen bipolaren Spannungsversorgung versorgt und/oder als Class-D-Verstärker und/oder mit einer konstanten Verstärkung ausgebildet. Diese bevorzugte Ausführungsform unterstreicht den Vorteil der Erfindung, einen Audioverstärker mit einer kostengünstigen Schaltung darstellen zu können. Die Versorgungsspannung der bipolaren Spannungsversorgung wird bevorzugt so gewählt, dass die Ausgangsverstärkerstufe die höchste benötigte Ausgangsspannung bei der minimal spezifizierten Impedanz der angeschlossenen Lautsprecher liefern kann. Die Ausbildung der Ausgangsverstärkerstufe als Class-D-Verstärker und/oder mit einer konstanten Verstärkung basiert darauf, dass derartige Verstärker über weite Bereiche des Eingangspegels des Zwischensignals einen konstant hohen Wirkungsgrad zeigen.

Bei einer möglichen, praktischen Umsetzung der Erfindung ist der Audioverstärker durch Einstellung des Maximalpegels zwischen einem Niederimpedanzbetrieb und einem Hochimpedanzbetrieb umschaltbar. Bei dem Niederimpedanzbetrieb werden die Lautsprecher bzw. die elektromechanischen Schallwandler direkt von dem Audioverstärker angesteuert, eine mögliche, typische Impedanz beträgt 4 Ohm. Im Hochimpedanzbetrieb betragen die Signalspannungen bzw. Signalpegel bis zu 70 Volt (70-Volt-Technologie) oder bis zu 100 Volt (100Volt-Technologie). Bevorzugt weisen die elektromechanischen Schallwandler Transformatoren und/oder Übertrager auf, welche das Ausgangssignal transformieren. Diese praktische Umsetzung unterstreicht nochmals den erfinderischen Gedanken, einen Audioverstärker vorzuschlagen, welcher flexibel bei verschiedenen Standards, insbesondere im Hochimpedanz- und Niederimpedanzbetrieb, einsetzbar ist, wobei aufgrund des gewählten Verstärkeraufbaus weder eine Mehrzahl von internen Versorgungsspannungen noch ein Übertrager am Ausgang des Audioverstärkers vorgesehen sein muss.

Bei einer Weiterbildung der Erfindung umfasst die Begrenzereinrichtung eine Analysatoreinheit und eine Limitereinheit, wobei die Analysatoreinheit auf Basis eines anliegenden Audioträgersignals ein Begrenzungssignal an die Limitereinheit ausgibt und/oder rückkoppelt. Das Audioträgersignal kann als das Eingangssignal, oder als ein bereits weiterverarbeitetes Signal ausgebildet sein. Analysatoreinheit und Limitereinheit bilden einen Regelkreis, wobei die Regelung so ausgestaltet ist, dass das Ausgangssignal den eingestellten Maximalpegel nicht überschreitet bzw. dass das Zwischensignal einen dazu korrespondierenden Maximalpegel im Kleinsignalbereich nicht überschreitet. Hierbei kann die Limitereinheit als eine Vorverstärkungseinrichtung, deren Verstärkung in Abhängigkeit des rückgekoppelten Begrenzungssignals eingestellt wird, und/oder als eine Dämpfungseinrichtung ausgebildet sein, welche auf Basis des rückgekoppelten Begrenzungssignals das anliegende Audioträgersignal dämpft. Optional kann die Analysatoreinheit ebenfalls als eine Begrenzerschaltgruppe ausgebildet sein, so dass die Begrenzereinrichtung die Begrenzung in zwei Stufen umsetzt, wobei in der ersten Stufe - in der Limitereinheit - eine Verstärkung und in der zweiten Stufe - in der Analysatoreinheit - eine Dämpfung gesteuert oder geregelt wird.

Bei einer möglichen Ausführungsform ist die Begrenzereinrichtung der Ausgangsverstärkerstufe vorgeschaltet und analysiert beziehungsweise begrenzt das analoge Audioträgersignal und bildet auf diese Weise das Zwischensignal. Bei einer alternativen Ausführungsform der Erfindung ist die Begrenzereinrichtung schaltungstechnisch so integriert, dass zunächst das Audioträgersignal pulsweitenmoduliert wird und dann das pulsweitenmodulierte Audioträgersignal begrenzt wird und damit das Zwischensignal bildet.

Bei einer Weiterbildung der Erfindung weist der Audioverstärker einen zuschaltbaren Hochpass, welcher zum Beispiel als Butter-Worth-Filter zweiter Ordnung ausgebildet ist, zur Filterung des Audioträgersignals auf. Der Audioverstärker ist bevorzugt so ausgebildet, dass der zuschaltbare Hochpass ausschließlich im Hochimpedanzbetrieb aktiviert ist. Wie bei allen Hochimpedanzverstärkern ist dies empfehlenswert, um die Übertrager in den Lausprechern nicht durch tieffrequente Signale in die Sättigung zu fahren.

Bei einer nächsten Weiterführung der Erfindung weist der Audioverstärker eine Eingangsverstärkereinrichtung auf, welche zur Konditionierung des Eingangssignals, insbesondere zur Anpassung der Eingangsimpedanz und des Eingangspegels ausgebildet ist.

Optional umfasst der Audioverstärker noch eine Levelstellereinrichtungzur Anpassung der Lautstärke und/oder der Verstärkung. Die Levelstellereinrichtung ist vorzugsweise so verschaltet, dass diese im Kleinsignalbereich auf das Audioträgersignal wirkt.

Die Erfindung umfasst eine Steuereinrichtung, welche als Schnittstelle, insbesondere manuelle oder elektrische/ elektronische Schnittstelle zu einem Benutzer, ausgebildet ist und welche die Einstellung des Maximalpegels erlaubt. Bevorzugt wirkt die Steuereinrichtung auf den zuschaltbaren Hochpass (soweit vorhanden) bzw. auf die Begrenzereinrichtung.

Obwohl vorliegend die Erfindung nur anhand einer Ausgangsverstärkerstufe und einer Begrenzereinrichtung beschrieben wurde, ist es im Rahmen der Erfmdung, dass der Audioverstärker mehrere Kanäle aufweist, welche jeweils eine Ausgangsverstärkerstufe aufweisen, die einer oder mehreren Begrenzereinrichtungen zugeordnet sind. Mit einem derartigen mehrkanaligen Audioverstärker ist es möglich, einen Mischbetrieb zwischen Niederimpedanz- und Hochimpedanzbetrieb zu fahren und auf diese Weise - zum Beispiel im Hinblick auf das vorher genannte Beispiel - ausgehend von einem Audioverstärker sowohl Niederimpedanzlautsprecher bei einer Impedanz von zum Beispiel 4 Ohm und Hochimpedanzlautsprecher im Direct-Drive-Modus bzw. in der 100-Volt- oder 70-Volt-Technologie anzusprechen. Bei einer Umkonfiguration einer derartigen Musikanlage muss nur die Betriebsart bzw. die Betriebsarten an der Steuereineinrichtung umgestellt werden.

Ein weiterer Gegenstand der Erfindung betrifft ein Verfahren zur Umkonfiguration eines Audioverstärkers nach einem der vorhergehenden Ansprüche zwischen einem Niederimpedanzbetrieb und einem Hochimpedanzbetrieb, wobei in einem ersten Schritt das Niederimpedanz- bzw. Hochimpedanzlautsprechersystem von dem Audioverstärker getrennt wird, in einem nächsten Schritt der Maximalpegel in den Hochimpedanz- bzw. Niederimpedanzbetrieb umgestellt wird und in einem letzten Schritt das Hochimpedanz- bzw. Niederimpedanzlautsprechersystem angeschlossen wird. Somit wird im Rahmen der Erfindung auch eine Musikanlage mit dem Audioverstärker offenbart, wobei ein Niederimpedanzlautsprechersystem und/oder Hochimpedanzlautsprechersystem nacheinander, wechselweise oder - bei mehreren Kanälen - gemeinsam betrieben werden kann.

### Kurze Beschreibung der Zeichnungen

Weitere Merkmale, Vorteile und Wirkung der Erfindung ergeben sich nachfolgenden Beschreibung eines bevorzugten Ausführungsbeispiels der Erfindung sowie den beigefügten Figuren. Dabei zeigen:
- Figur 1: ein Blockdiagramm eines Audioverstärkers gemäß der Erfindung;
- Figur 2: ein Blockschaltbild der Analysatoreinheit in dem Audioverstärker in der Figur 1.

### Ausführugsform(en) der Erfindung

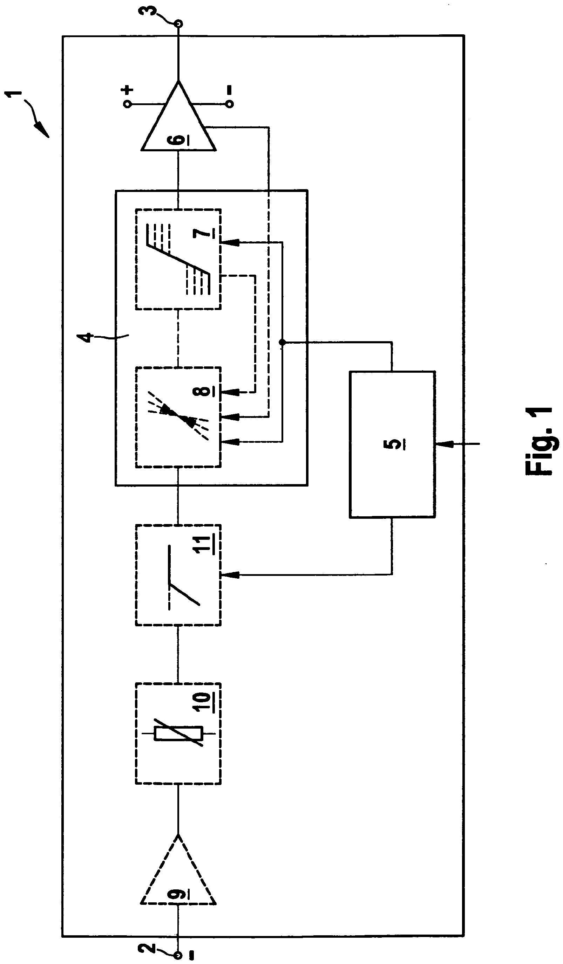

Die Figur 1 zeigt in einem schematischen Blockdiagramm einen Audioverstärker 1, welcher zur Verstärkung eines Eingangssignals, das an einer Eingangsschnittstelle 2 anliegt, zu einem Ausgangssignal, welches an einer Ausgangsschnittstelle 3 anliegt, ausgebildet ist. Der Audioverstärker 1 ist so realisiert, dass an der Ausgangsschnittstelle 3 ein Ausgangssignal für ein Lautsprechersystem (nicht gezeigt) in einem Niederimpedanzbetrieb, zum Beispiel ausgelegt für eine Impedanz von 4 Ohm, oder in einem Hochimpedanzbetrieb mit einem Ausgangssignal, dessen Signalpegel oder Signalspannung effektiv bis zu 70 Volt und/oder bis zu 100 Volt beträgt.

In dem Blockdiagramm sind die wichtigsten Bestandteile mit durchgezogener Linie dargestellt, die optionalen Bestandteile des Audioverstärkers 1 sind gestrichelt illustriert. Ausgehend von der Eingangsschnittstelle 2 wird das Eingangssignal optional über weitere Funktionsbaugruppen - im Ursprungszustand bzw. im bearbeiteten Zustand auch als Audioträgersignal bezeichnet - zu einer Begrenzereinrichtung 4 geleitet, welche in Abhängigkeit eines Steuerungssignals einer Steuereinheit 5 das Audioträgersignal begrenzt und als begrenztes Zwischensignal an eine Ausgangsverstärkerstufe 6 weitergegeben.

Die Ausgangsverstärkerstufe 6 ist als ein Class-D-Verstärker ausgebildet. Der Class-D-Verstärker arbeitet in einem Schaltbetrieb, wobei der Wirkungsgrad theoretisch 100 %, praktisch durch Umschalt- und Leitendverluste einen Wirkungsgrad um die 90 % erzielt. Ein Class-D-Verstärker kann in einer beispielhaften Ausführung in drei Bereiche unterteilt werden, wobei der erste Bereich den Eingang für das Zwischensignal, einen Dreiecks-Signal-Generator und einen Komparator, der zweite Bereich eine Schalt-Verstärkungsstufe und der dritte Bereich einen Tiefpassfilter umfasst.

In dem ersten Bereich wird das durch den Signalgenerator erzeugte vorzugsweise dreiecksförmig Signal durch das Zwischensignal moduliert, wobei der Komparator die Spannungswerte des Zwischensignals mit dem des Signals des Signalgenerators vergleicht und dann seinen Ausgang an- oder abschaltet, abhängig davon, welches der beiden Signale gerade eine höhere Spannung aufweist. Der erste Bereich stellt somit eine Puls-Weiten-Modulation (PWM) dar, welche als Ausgangssignal ein Rechtecksignal mit der gleichen Frequenz wie das Signal des Signalgenerators, jedoch mit unterschiedlich breiten Rechtecken, den Pulsbreiten, bereitstellt. Letztere bilden die Informationen über Amplitude und Frequenz des Audiosignals ab. In dem zweiten Bereich wird das PWM-Signal beispielsweise durch Transistoren verstärkt, wobei die Transistoren voll durchgeschaltet bzw. abgeschaltet sind, sie sind somit entweder ein- oder ausgeschaltet, woran auch der Grund für die hohe Effizienz dieses Schaltungsdesigns liegt. In dem dritten Bereich wird das durch den Signalgenerator erzeugtes Trägersignal ausgefiltert, wobei üblicherweise ein passives LC-Filter verwendet wird. Der Class-D-Verstärker kann aufgrund des internen Aufbaus und der Unabhängigkeit des Wirkungsgrades von der Aussteuerung auch in einem Ausgangspannungsbereich betrieben werden, der nur einen Bruchteil der tatsächlich zur Verfügung stehenden Betriebsspannung entspricht. Nebenbei sei bemerkt, dass die vorliegende Erfindung sich nicht auf eine bestimmte Topologie eines Class-D-Verstärkers beschränkt und insbesondere nicht an ein bestimmtes Modulations- oder Rückkopplungsschema des Class-D-Verstärkers gebunden ist.

Durch die über die Steuereinheit 5 einstellbare Begrenzungseinrichtung 4 findet eine symmetrische Begrenzung des Audioträgersignals statt, so dass an der nachfolgenden Ausgangsverstärkerstufe 6 ein begrenztes Zwischensignal anliegt. Die Höhe der jeweiligen Begrenzung wird von der Steuereinheit 5 je nach gewählter Betriebsart passend vorgegeben. Da der nachfolgende Class-D-Verstärker eine konstante Verstärkung hat und aufgrund der gewählten Höhe der Versorgungsspannung immer im linearen Bereich arbeitet, verhält sich der gesamte Audioverstärker 1 von außen betrachtet wie ein herkömmlicher Verstärker, bei dem die interne Versorgungsspannung virtuell stufenlos eingestellt werden kann. Die Begrenzung wird dabei so gestaltet, dass die maximale Ausgangsspannung an der Ausgangsschnittstelle 3 nicht durch die interne Versorgungsspannung, sondern durch die Begrenzungseinrichtung 4 im Kleinsignalbereich bestimmt wird. Die Versorgungsspannung für die Ausgangsverstärkerstufe 6 wird so gewählt, dass diese die höchste benötigte Ausgangsspannung bei der minimal spezifizierten Impedanz liefern kann.

Auch im Niederimpedanzbetrieb wird die Betriebsspannung nicht umgeschaltet oder verringert, die als Endstufenblock ausgebildete Ausgangsverstärkerstufe 6 wird weiterhin mit der hohen Betriebsspannung versorgt. Stattdessen wird die Begrenzung der Ausgangsspannung an der Ausgangsschnittstelle 3 durch die einstellbare Begrenzungseinrichtung 4 im Kleinsignalbereich erreicht. Die sogenannte Clipgrenze wird so eingestellt, dass die damit erreichbare maximale Ausgangsspannung an der Ausgangsschnittstelle 3 zu der gewählten Betriebsart passt.

Die Begrenzungseinrichtung 4 kann in einer möglichen Ausführungsform wie in der Figur 1 dargestellt aus einer Analysatoreinheit 7 und einer Limitereinheit 8 ausgebildet sein. Funktionell betrachtet analysiert die Analysatoreinheit 7 das anliegende Audioträgersignal und gibt ein Begrenzungssignal an die Limitereinheit 8 aus, so dass diese das Audioträgersignal angepasst verstärken bzw. dämpfen kann. Optional dämpft auch die Analysatoreinheit 7 das Audioträgersignal.

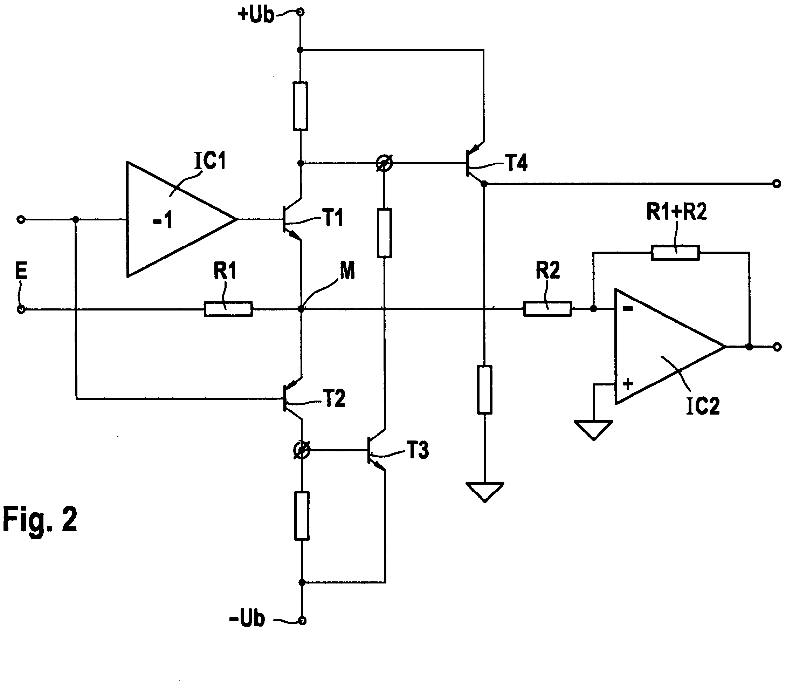

Eine mögliche Realisierung der Analysatoreinheit 7 ist in der Figur 2 in einem schematischen Stromlaufplan dargestellt. Das Audioträgersignal wird der Analysatoreinheit 7 an einem Eingang E über einen Widerstand R1 zugeführt. Der Widerstand R 1 bildet mit einem Widerstand R 2 einen Spannungsteiler. Der gemeinsame Mittelpunkt M dieses Spannungsteilers ist als Knoten zugleich an die Emitter von Transistoren T1 und T2 angeschlossen, wobei die Signalbegrenzung durch die beiden Transistoren T1 und T2 erfolgt. Wenn diese im Sperrzustand sind, fließt der Strom des Audioträgersignals durch den Widerstand R1 auf einen negativen Eingang eines Operationsverstärkers IC 2, der auf virtueller Masse liegt. Da der Operationsverstärker IC2 mit R1 plus R2 gegengekoppelt ist, ist die Verstärkung des Begrenzers null dB. Der Einsatzbereich der Begrenzungseinrichtung 4 wird durch eine positive Steuerspannung aus der Steuereinheit 5 vorgegeben, die an dem Eingang S anliegt. Um eine symmetrische Signalbegrenzung zu erreichen, wird das Steuersignal S mithilfe von einem Operationsverstärker IC1 invertiert. Das invertierte Steuersignal wird der Basis von T1, das nicht invertierten Steuersignal der Basis von T2 zugeführt. Überschreitet das Audioträgersignal am Mittelpunkt des Spannungsteilers R1 und R2 die Steuerspannung um die Basis-Mitte-Flussspannung, wird T2 leiten. T2 klammert dadurch den Eingangspegel im positiven Spannungsbereich auf die Höhe der Steuerspannung plus eine Diodenstrecke. Auf gleiche Weise klammert T1 das Eingangssignal im negativen Spannungsbereich. Auf diese Weise erfolgt durch die Wahl der Steuerspannung eine symmetrische Signalbegrenzung des Ansteuersignals der folgenden Ausgangsverstärkerstufe 6. Die beiden Transistoren T3 und T4 sind nur nötig, wenn die Limitereinheit 8 vorhanden ist. Diese Transistoren T3 und T4 stellen im Falle der einsetzenden Signalbegrenzung in der Analysatoreinheit 7 der Limitereinheit 8 ein Ansteuersignal zur Verfügung. Dieses Ansteuersignal ist im Ruhezustand 0 Volt, bei einsetzender Signalbegrenzung geht es auf plus UB, da T4 leitend wird. Durch diesen Regelkreis kommt es nicht zu einem harten Clippen des Audiosignals in der Begrenzereinrichtung 4, sondern die vorgeschaltete Limitereinheit 8 reduziert entsprechend die Verstärkung bis die Einsatzgrenze der Begrenzung durch die Analysatoreinheit 7 gerade erreicht ist.

Als weitere Funktionsblöcke weist der Audioverstärker 1 optional die folgenden Komponenten auf: Eine Eingangsverstärkungseinrichtung 9 nimmt die impedanz- und pegelmäßige Anpassung des Eingangssignals an die nachfolgenden Stufen des Audioverstärkers 1 vor. Für einen Verstärker gemäß dieser Erfindung ist es dabei unerheblich, ob der Eingangsverstärker für symmetrische oder unsymmetrische Eingangssignale konstruiert wurde. Ein Levelsteller 10 dient der Lautstärke- und Verstärkungsanpassung. Der Levelsteller 10 ist für die Funktion des Audioverstärkers 1 nicht unbedingt notwendig und kann optional auch entfallen. Ein schaltbare Hochpass 11 wird von der Steuereinheit 5 ausschließlich in der Betriebsart Direct-Drive und/oder im Hochimpedanzbetrieb aktiviert. Wie bei allen Hochimpedanzverstärkern ist dies empfehlenswert, um die Übertrager in den Lautsprechern der angeschlossenen Linie nicht durch tieffrequente Signale in die Sättigung zu fahren. Eine typische Realisierung dieses Hochpasses 11 ist ein Butter-Worth-Filter 2. Ordnung mit einer Grenzfrequenz von 50 Hz. Vorstellbar ist auch die Möglichkeit die Grenzfrequenz des Hochpasses 11 stufig oder stufenlos durchstimmbar zu gestalten. Im Niederimpedanzbetrieb wird der Hochpass 11 durch die Steuereinheit 5 deaktiviert. Die Limitereinheit 8 stellt als optional ergänzende Funktion sicher, dass die Verzerrungen des Ausgangssignals unter allen Umständen einen gewissen Prozentsatz (z.B. 1%) nicht überschreiten. Wenn der Audioverstärker 1 seinen linearen Bereich verlassen müsste, z.B. bei Erreichen der Betriebsspannungsgrenze oder bei einer Begrenzung durch die Analysatoreinheit 7 nimmt die Limitereinheit 8 die Verstärkung soweit zurück, dass die entstehenden Verzerrungen des Ausgangssignals beschränkt bleiben. Bei einer alternativen Betriebsart kann es auch sinnvoll sein, dass die Steuereinheit 5 eine Verstärkungsanpassung des gesamten Audioverstärkers 1 in der Limitereinheit 8 durchführt. Damit kann die Verstärkung in den unterschiedlichen Betriebsarten frei gewählt werden, es kann z.B. eine konstante Eingangsempfindlichkeit sowohl im Niederimpedanz- als auch im Hochimpedanzbetrieb erzielt werden.

## Patentansprüche

1. Audioverstärker (1) zur Verstärkung eines Eingangssignals in ein Ausgangssignal
mit einer Ausgangsverstärkerstufe (6),
wobei die Ausgangsverstärkerstufe (6) zur Verstärkung eines Zwischensignals in das Ausgangssignal und
wobei die Ausgangsverstärkerstufe (6) als ein in Schaltbetrieb arbeitender Verstärker ausgebildet ist,
mit einer Begrenzereinrichtung (4), welche programmtechnisch und/oder schaltungstechnisch ausgebildet ist, auf Basis des Eingangssignals das Zwischensignal zu erzeugen, wobei der Pegel des Zwischensignals in Abhängigkeit eines stellbaren Maximalpegels stets derart begrenzt ist, dass das Ausgangssignal unabhängig vom Eingangssignal den Maximalpegel nicht überschreitet,
eine Steuereinrichtung, welche zur Einstellung des Maximalpegels ausgebildet ist und die Begrenzereinrichtung ansteuert, wobei die Steuereinrichtung als eine Schnittstelle zu einem Benutzer ausgebildet ist,
**gekennzeichnet durch**
wobei der Audioverstärker **durch** Einstellung des Maximalpegels zwischen einem Niederimpedanzbetrieb und einem Hochimpedanzbetrieb als Betriebsarten umschaltbar ist, und wobei zu einer Umkonfiguration der Betriebsarten nur die Betriebsart an der Steuereinrichtung umgestellt werden muss.

2. Audioverstärker (1) nach Anspruch 1, **dadurch gekennzeichnet, dass** die Ausgangsverstärkerstufe (6) mit einer einzigen bipolaren Spannungsversorgung versorgt ist und/oder die Ausgangsverstärkerstufe als Class-D Verstärker und/oder mit einer konstanten Verstärkung ausgebildet ist.

3. Audioverstärker (1) nach einem der vorhergehenden Ansprüche, **dadurch gekennzeichnet, dass** die Begrenzereinrichtung (4) eine Analysatoreinheit (7) und eine Limitereinheit (8) aufweist, wobei die Analysatoreinheit (7) auf Basis eines anliegenden Audioträgersignals ein Begrenzungssignal an die Limitereinheit (8) ausgibt und/oder rückkoppelt.

4. Audioverstärker (1) nach Anspruch 3, **dadurch gekennzeichnet, dass** die Limitereinheit (7) als eine Vorverstärkungs- und/oder eine Dämpfungseinrichtung ausgebildet ist.

5. Audioverstärker (1) nach einem der vorhergehenden Ansprüche, **gekennzeichnet durch** einen schaltbaren Hochpass (11) zur Filterung des Audioträgersignals, wobei der schaltbare Hochpass (11) bevorzugt ausschließlich im Hochimpedanzbetrieb aktiviert ist.

6. Audioverstärker (1) nach einem der vorhergehenden Ansprüche, **gekennzeichnet durch** eine Eingangsverstärkereinrichtung (9) zur Konditionierung des Eingangssignals.

7. Audioverstärker (1) nach einem der vorhergehenden Ansprüche, **gekennzeichnet durch** eine Levelstellereinrichtung (10) zur Lautstärke- und/oder Verstärkungsanpassung des Audioverstärkers (1).

8. Audioverstärker (1) nach einem der vorhergehenden Ansprüche, **gekennzeichnet durch** die Steuereinrichtung (5), welche zur Einstellung des Maximalpegels ausgebildet ist und den schaltbaren Hochpass (11) ansteuert.

9. Audioverstärker (1) nach einem der vorhergehenden Ansprüche, **gekennzeichnet durch** eine Mehrzahl von Kanälen, wobei jeder Kanal eine Ausgangsverstärkerstufe (6) und eine zugeordnete Begrenzereinrichtung (4) aufweist.

10. Verfahren zur Umkonfiguration eines Audioverstärkers (1) nach einem der vorhergehenden Ansprüche zwischen einem Niederimpedanzbetrieb und einem Hochimpedanzbetrieb, **gekennzeichnet durch** die Schritte:
- Trennen eines Niederimpedanz- bzw. Hochimpedanzlautsprechersystems von dem Audioverstärker (1);
- Umstellen des Maximalpegels in den Hochimpedanz- bzw. Niederimpedanzbetrieb;
- Anschließen des Hochimpedanz- bzw. Niederimpedanzlautsprechersystems.

## Claims

1. Audio amplifier (1) for amplifying an input signal to produce an output signal,
having an output amplifier stage (6),
wherein the output amplifier stage (6) is designed to amplify an intermediate signal to produce the output signal and
wherein the output amplifier stage (6) is in the form of an amplifier operating in switched mode,
having a limiter device (4), the programming and/or circuitry of which are/is designed to take the input signal as a basis for producing the intermediate signal, wherein the level of the intermediate signal is always limited on the basis of an adjustable maximum level such that the output signal does not exceed the maximum level, regardless of the input signal,
a control device which is designed to set the maximum level and actuates the limiter device, wherein the control device is in the form of an interface to a user,
**characterized by**
the audio amplifier being switchable by setting the maximum level between a low-impedance mode and a high-impedance mode as modes of operation, and wherein reconfiguring the mode of operation requires only the mode of operation on the control device to be changed over.

2. Audio amplifier (1) according to Claim 1, **characterized in that** the output amplifier stage (6) is supplied by means of a single bipolar voltage supply, and/or the output amplifier stage is in the form of a class-D amplifier and/or is designed to have a constant gain.

3. Audio amplifier (1) according to one of the preceding claims, **characterized in that** the limiter device (4) has an analyser unit (7) and a limiter unit (8), wherein the analyser unit (7) takes an applied audio carrier signal as a basis for outputting and/or feeding back a limiting signal to the limiter unit (8).

4. Audio amplifier (1) according to Claim 3, **characterized in that** the limiter unit (8) is in the form of a preamplification and/or attenuation device.

5. Audio amplifier (1) according to one of the preceding claims, **characterized by** a switchable high-pass filter (11) for filtering the audio carrier signal, wherein the switchable high-pass filter (11) is preferably activated exclusively in the high-impedance mode.

6. Audio amplifier (1) according to one of the preceding claims, **characterized by** an input amplifier device (9) for conditioning the input signal.

7. Audio amplifier (1) according to one of the preceding claims, **characterized by** a level adjuster device (10) for matching the volume and/or gain of the audio amplifier (1).

8. Audio amplifier (1) according to one of the preceding claims, **characterized by** the control device (5), which is designed to set the maximum level and actuates the switchable high-pass filter (11).

9. Audio amplifier (1) according to one of the preceding claims, **characterized by** a plurality of channels, wherein each channel has an output amplifier stage (6) and an associated limiter device (4).

10. Method for reconfiguring an audio amplifier (1) according to one of the preceding claims between a low-impedance mode and a high-impedance mode, **characterized by** the following steps:
- a low-impedance or high-impedance loudspeaker system is isolated from the audio amplifier (1);
- the maximum level is changed over to the high-impedance or low-impedance mode;
- the high-impedance or low-impedance loudspeaker system is connected.

## Revendications

1. Amplificateur audio (1) pour amplifier un signal d'entrée en un signal de sortie,
comprenant un étage amplificateur de sortie (6), l'étage amplificateur de sortie (6) étant configuré pour amplifier un signal intermédiaire en le signal de sortie et
l'étage amplificateur de sortie (6) étant réalisé sous la forme d'un amplificateur fonctionnant en mode commuté,
comprenant un dispositif limiteur (4) qui est configuré par technique de programmation et/ou par technique de commutation pour générer le signal intermédiaire en se basant sur le signal d'entrée, le niveau du signal intermédiaire étant toujours limité en fonction d'un niveau maximum réglable de sorte que le signal de sortie, indépendamment du signal d'entrée, ne dépasse pas le niveau maximum,
un dispositif de commande qui est configuré pour régler le niveau maximum et qui commande le dispositif limiteur, le dispositif de commande étant réalisé sous la forme d'une interface avec un utilisateur, **caractérisé par**
l'amplificateur audio pouvant, en réglant le niveau maximum, être permuté entre un fonctionnement à basse impédance et un fonctionnement à haute impédance en tant que modes de fonctionnement et seul le mode de fonctionnement sur le dispositif de commande devant être modifié pour une reconfiguration des modes de fonctionnement.

2. Amplificateur audio (1) selon la revendication 1, **caractérisé en ce que** l'étage amplificateur de sortie (6) est alimenté avec une seule source de tension bipolaire et/ou l'étage amplificateur de sortie est réalisé sous la forme d'un amplificateur de classe D et/ou avec un gain d'amplification constant.

3. Amplificateur audio (1) selon l'une des revendications précédentes, **caractérisé en ce que** le dispositif limiteur (4) présente une unité d'analyse (7) et une unité de limitation (8), l'unité d'analyse (7) délivrant et/ou renvoyant par contre-réaction un signal de limitation à l'unité de limitation (8) en fonction d'un signal de porteuse audio présent.

4. Amplificateur audio (1) selon la revendication 3, **caractérisé en ce que** l'unité de limitation (8) est réalisée sous la forme d'un dispositif de préamplification et/ou d'atténuation.

5. Amplificateur audio (1) selon l'une des revendications précédentes, **caractérisé par** un filtre passe-haut commutable (11) pour filtrer le signal de porteuse audio, le filtre passe-haut commutable (11) étant de préférence activé uniquement dans le mode de fonctionnement à haute impédance.

6. Amplificateur audio (1) selon l'une des revendications précédentes, **caractérisé par** un dispositif amplificateur d'entrée (9) pour conditionner le signal d'entrée.

7. Amplificateur audio (1) selon l'une des revendications précédentes, **caractérisé par** un dispositif de réglage du niveau (10) pour l'adaptation du volume et/ou du gain d'amplification de l'amplificateur audio (1).

8. Amplificateur audio (1) selon l'une des revendications précédentes, **caractérisé par** le dispositif de commande (5) qui est configuré pour régler le niveau maximum et qui commande le filtre passe-haut commutable (11).

9. Amplificateur audio (1) selon l'une des revendications précédentes, **caractérisé par** une pluralité de canaux, chaque canal présentant un étage amplificateur de sortie (6) et un dispositif limiteur (4) associé.

10. Procédé de reconfiguration d'un amplificateur audio (1) selon l'une des revendications précédentes entre un fonctionnement à basse impédance et un fonctionnement à haute impédance, **caractérisé par** les étapes suivantes :
- déconnexion d'un système de haut-parleurs à basse impédance ou à haute impédance de l'amplificateur audio (1) ;
- modification du niveau maximum dans le mode de fonctionnement à basse impédance ou de fonctionnement à haute impédance ;
- connexion du système de haut-parleurs à basse impédance ou à haute impédance.
